# EUROPEAN PATENT APPLICATION

(11) **EP 1 657 560 A1**
(43) Date of publication of application: **17.05.2006**
(21) Application number: 05020679.6
(22) Date of filing: 22.09.2005
(51) Int. Cl.: G01R 31/36, G01R 31/02

(54) **Apparatus and method for detecting a short of a battery connector**

(30) Priority: 23.09.2004 KR 2004076254
(71) Applicant: LG Electronics Inc., Yongdungpo-gu Seoul (KR)
(72) Inventor: Lee, Jun-Ho, Sungnam, Gyeonggi-Do (KR)
(74) Representative: Katérle, Axel

(57) **Abstract**

A short circuit detection apparatus and method thereof for detecting a pin-to-pin short or a pin-to-ground short of a wireless communications terminal battery connector is described. The detection apparatus monitors the voltage level of the battery and indicates a pin-to-ground short when the battery voltage is at ground level, and indicates a pin-to-pin short when the battery level is slightly above ground. Upon detection of a ground, the short circuit detection apparatus indicates the presence of the short and of its type by a visual or audible indication or both.

## Description

### BACKGROUND OF THE INVENTION

### 1. Field of the Invention

The present invention relates to a wireless communications terminal, and particularly, to an apparatus and method for detecting a short circuit and the type of short circuit of a battery connector and for providing an audible and visual indication thereof.

### 2. Background of the Related Art

Rapid development of communication technologies and an increase in user requirements have recently enabled wireless communications terminals (hereinafter, referred to as a 'terminal') to have multiple functions in addition to the typical calling function, for instance, terminals may function as a digital camera or an MP3 player.

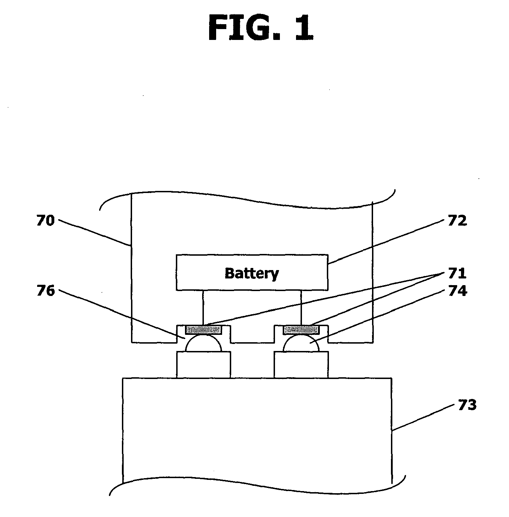

In general, the terminal is commonly powered by an internal battery, which must be charged periodically to allow continual operation of the terminal. Such charging is often accomplished by placing the terminal in an external charger. Fig. 1 illustrates a wireless communications terminal connected to a charger.

As illustrated in Fig. 1, when a terminal 70 having a battery 72 is correctly coupled with a charger 73, a charging pin 74 is partially inserted into an inserting unit 76 positioned at a lower portion of the terminal 70, and thus the charging pin 74 contacts with a plate-shaped battery pin 71. When the charging pins 74 contact the battery pins 71, the charger 73 applies a charging current to the battery 72, thereby charging the battery 72.

However, a battery connector of the conventional wireless communications terminal is typically exposed subjecting the battery connector pins to contamination or corrosion. Such contamination or corrosion may create a short circuit between battery connector pins or between one or more pins and ground thereby impeding charging. Further, if the short circuit continues for a length of time, the battery may be subject to damage, may overheat, or possibly may explode.

### SUMMARY OF THE INVENTION

Therefore, an object of the present invention is to provide an apparatus and method for detecting a short circuit of a battery pin in a wireless communications terminal and providing an audible and a visual indication of the short circuit thereby improving the operations of the wireless communications terminal.

To achieve these and other advantages and in accordance with the purpose of the present invention, as embodied and broadly described herein, there is provided a short detection apparatus comprising: a battery connector comprising an anode and a cathode pin; a short circuit detection unit for detecting a short circuit of the battery connector; a short circuit type detection unit for detecting the type of short circuit; and a controller for providing an audible and a visual indication of the detected short circuit and short circuit type.

Preferably, the short circuit detection unit is connected to the anode pin of the battery connector and to ground.

Preferably, the short type detection unit includes a diode connected to the anode pin of the battery connector for detecting a voltage more than a particular level, and a NOR gate connected to the diode.

Preferably, the type of short circuit is a pin-to-pin short or a pin-to-ground short.

To achieve these and other advantages and in accordance with the purpose of the present invention, there is provided a short circuit detection method comprising: detecting a short circuit of a battery connector; detecting a short circuit type when the short circuit is detected; and audibly and visually indicating the detected short circuit and short circuit type.

Preferably, the type of short circuit is a pin-to-pin short or a pin-to-ground short.

Preferably, the short circuit and the short circuit type are detected using a potential of the anode pin of the battery connector, wherein a pin-to-ground short circuit is detected when the voltage of the anode pin of the battery connector is at earth voltage, and a pin-to-pin short is detected when the voltage of anode pin of the battery connector is slightly greater than the earth voltage.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention.

### In the drawings:

Fig. 1 shows a wireless communications terminal connected to a battery charger;
Fig. 2 shows a short circuit detection apparatus of a battery connector in a wireless communications terminal according to the present invention; and
Fig. 3 is a flowchart showing sequential steps of a short circuit detection method of a battery connector of a wireless communications terminal according to the present invention.

### DETAILED DESCRIPTION OF THE PREFERRED EMBODIMENTS

Reference will now be made in detail to the preferred embodiments of the present invention, examples of which are illustrated in the accompanying drawings.

The present invention discloses an apparatus and method for detecting electrical short circuits of a battery connector pin of a wireless communications terminal.

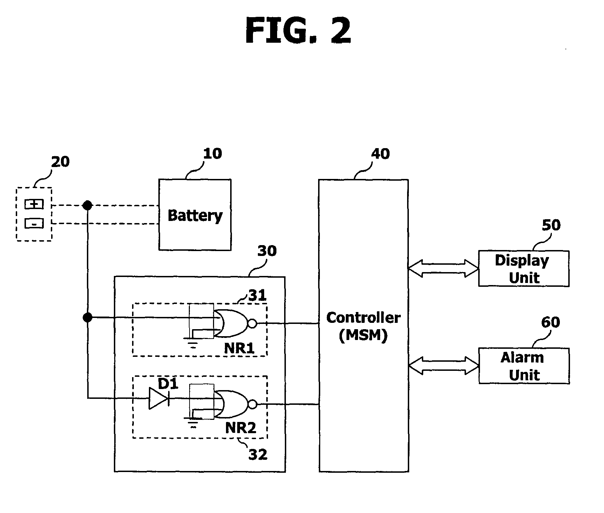

Fig. 2 illustrates a short circuit detection apparatus for a battery connector of a wireless communications terminal according to the present invention. As illustrated in Fig. 2, the short circuit detection apparatus of a terminal according to the present invention comprises: a battery connector 20 having a cathode and an anode pin connected to a battery 10; a short circuit detection unit 30 for detecting a short circuit and the type of short circuit of the battery connector 20; a controller 40 for displaying the short circuit condition and the type of short circuit detected by the short circuit detection unit 30; and a display unit 50 and an alarm unit 60. Preferably, the display unit 50 is a liquid crystal display (LCD), and the controller 40 is a Wireless Station Modem (MSM).

The short detecting unit 30 further comprises a short circuit detector 31 for detecting a short circuit of the battery connector 20, and a short circuit type detector 32 for detecting the type of short circuit thereof on the basis of a potential of the battery connector 20. The short circuit detector 31 is a NOR gate, NR1, having two input pins; one pin is connected to the anode terminal of the battery connector 20, and the other pin is connected to ground. The short circuit type detector 32 comprises a diode D1 for detecting a voltage less than a particular level of the battery connector 20, and a NOR gate NR2 connected to the diode D1 and ground.

In one embodiment of the present invention, the short circuit detector 31 and the short circuit type detector 32 are simultaneously used but they may be used independently.

Operation of the short circuit detecting apparatus of a battery connector according to the present invention having such construction will now be explained in detail with reference to Fig. 2.

In general, when the battery connector 20 connected to the battery 20 does not have a short circuit, the normal voltage of the anode is present at the short circuit detector 31 and the short circuit type detector 32.

Conversely, if an electrical short circuit is present due to contamination or corrosion between the anode and cathode terminals of the battery connector 20 (a pin-to-pin short), or between the anode terminal of the battery connector 20 and ground (a pin-to-ground), a low voltage level is present at the short circuit detector 31 and the short circuit type detector 32.

The NOR gates, NR1 and NR2, provide a high level output, a logic "one", when both of their inputs gates are low signals or logic "zeros." Because the second input gate of each NR1 and NR2 is held at logic zero, the output of NR1 and NR2 is the inverse of the first input gate. When a pin-to-ground short is present, the first input pin of NR1 of the short circuit detector 31 is held at ground, a logic zero, and the short circuit detector outputs a logic one to the controller 40. At the same time, the anode of diode D1 is connected to ground through the pin-to-ground short. Because diode D1 conducts only when the diode anode to cathode voltage exceeds the forward bias voltage, diode D1 is not conducting when a pin-to-ground short is present, and the second input gate of NR2 of the short circuit type detector 32 appears as an open circuit. An open circuit on a NOR gate is a logic one, therefore when a pin-to-ground short is present, NR2 provides a logic zero to controller 40 thereby indicating the short circuit is a pin-to-ground short.

When a pin-to-pin short is present, the voltage of the anode pin is low, but higher than the ground potential. In this circumstance, the low anode voltage, a logic zero, is applied to the first gate of NR1, and NR1 outputs a logic one to controller 40. The low anode voltage is also applied to the anode of diode D1, and if the low anode voltage is greater than the forward biasing voltage of diode D1, diode D1 conduct the low anode voltage to the second input gate of NR2. The low anode voltage appears as a logic zero and NR2 of the short circuit type detector provides a logic one to the controller 40 thereby indicating the short circuit is a pin-to-pin short.

Accordingly, the controller 40 determines the type of short circuit of the battery connector 20 by using the outputs of the short circuit detector 31 and the short circuit type detector 32, thereby displaying the type of short circuit on the display unit 50 and the generating an alarm through the alarm unit 60.

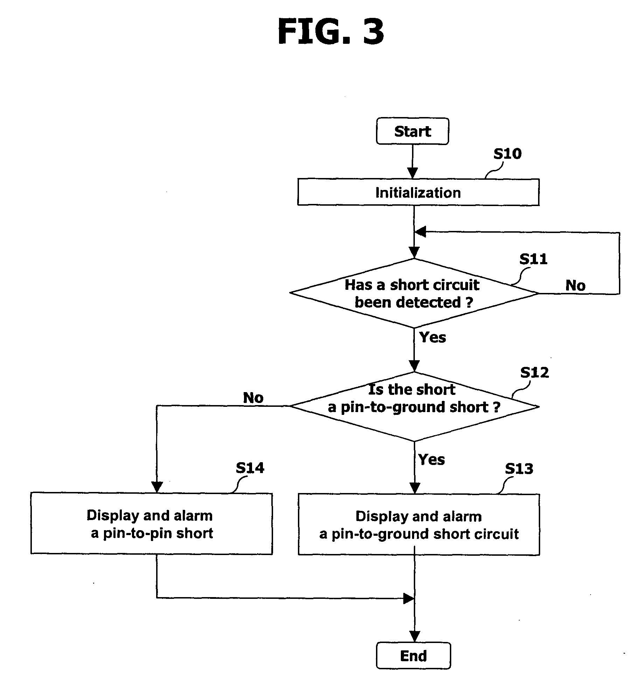

A method for detecting a short circuit of a battery connector pin according to the present invention will now be explained with reference to Fig. 3.

As illustrated in Fig. 3, when power is applied to the terminal, the controller 40 performs an initialization process of the terminal (S10).

After performing the initialization process, the controller 40 provides services of voice communication, data communication, and other multimedia according to user requirements. The controller 40 also detects a short circuit condition and the short circuit types of the battery connector 20 periodically or according to the user requirements. The short circuit types of the battery connector 20 is determined by an output of the short circuit detection unit 30, and more particularly, by an outputs of the short circuit detector 31 and the short circuit type detector 32.

First, the controller 40 checks whether the output of the short circuit detector 31 is a high level, thereby indicating a battery connector 20 short circuit (S11).

Upon detecting the short circuit condition of the battery connector 20, the controller 40 checks whether the output of the short circuit type detector 32 is a high level, and accordingly determines whether the detected short circuit is created by a pin-to-pin short or a pin-to-ground short in the battery connector 20 (S12).

If the short circuit type detector 32 is a high level thereby indicating a pin-to-ground short, the controller 40 informs the user of the short circuit type through the display unit 50 and/or the alarm unit 60 (S13). If the short circuit type detector 32 is a low level thereby indicating a pin-to-pin short, the controller 40 informs the user of the short state between battery connector pins through the display unit 50 and/or the alarm unit 60 (S14).

As described above, in the present invention, the short state of the battery connector is detected by the detecting unit and provides an audible and a visual indication to the user. As a result, an internal circuitry of the terminal is prevented from being damaged by a short circuit of the battery connector resulting in improved reliability of the terminal.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalence of such metes and bounds are therefore intended to be embraced by the appended claims.

## Claims

1. A wireless communications terminal comprising:
a battery connector;
a short circuit detection unit for detecting a short circuit of the battery connector and for detecting a short circuit type of the battery connector; and
a controller for indicating the short circuit and the short circuit type detected by the short circuit detection unit.

2. The terminal of claim 1, wherein the battery connector comprises an anode pin and a cathode pin.

3. The terminal of claim 1, wherein the short detection unit comprises:
a short circuit detector for detecting the short circuit using a voltage potential of the anode pin; and
a short circuit type detector for detecting the short circuit type using the voltage potential of the anode pin.

4. The terminal of claim 3, wherein the short circuit detector comprises a first NOR gate logic circuit having a first input pin and a second input pin, wherein the first NOR gate logic circuit provides an indication responsive to the short circuit.

5. The terminal of claim 4, wherein the first input pin is connected to the anode pin and the second input pin is connected to ground.

6. The terminal of claim 3, wherein the short circuit type detector comprises:
a diode connected to the anode pin of the battery connector for detecting a battery voltage; and
a second NOR gate logic circuit having a third input pin and a fourth input pin, wherein the second NOR gate logic circuit provides an indication responsive to the short circuit type.

7. The terminal of claim 6, wherein the third input pin is connected to the diode and the fourth input pin is connected to ground.

8. The terminal of claim 1, wherein the type of short circuit is a short between the anode pin and the cathode pin.

9. The terminal of claim 1, wherein the type of short circuit is a short between the anode pin and the ground.

10. The terminal of claim 1, wherein the controller provides a visual indication of the detection of the short circuit.

11. The terminal of claim 1, wherein the controller provides an audible indication of the detection of the short circuit.

12. The terminal of claim 1, wherein the controller provides a visual indication of the detection of the short circuit type.

13. The terminal of claim 1, wherein the controller provides an audible indication of the short circuit type.

14. A short circuit detection apparatus comprising:
a battery connector further comprising an anode pin and a cathode pin;
a means for detecting a short circuit using a voltage potential of the anode pin;
a means for detecting a short circuit type using the voltage potential of the anode pin; and
a controller for indicating the short circuit and the short circuit type detected by the short circuit detection unit.

15. The apparatus of claim 14, wherein means for detecting a short circuit comprises a first NOR gate logic circuit having a first input pin connected to the anode pin and a second input pin connected to a ground, wherein the first NOR gate logic circuit provides an indication responsive to the short circuit.

16. The apparatus of claim 14, wherein the means for detecting the short circuit type comprises:
a diode connected to the anode pin of the battery connector for detecting a battery voltage; and
a second NOR gate logic circuit having a third input pin connected to the diode and a fourth input connected to ground, wherein the second NOR gate logic circuit provides an indication responsive to the short circuit type.

17. The apparatus of claim 14, wherein the type of short circuit is a short between the anode pin and the cathode pin or a short between the anode pin and the ground.

18. The apparatus of claim 14 further comprising a means for displaying a visual indication of the short circuit and the short circuit type.

19. The apparatus of claim 14 further comprising a means for providing an audible indication of the short circuit and the short circuit type.

20. A method for detecting a short circuit of a wireless communications battery connector, the method comprising:
detecting a short circuit of the battery connector, the battery connector comprising an anode pin and a cathode pin;
detecting a short circuit type; and
indicating the detected short circuit and the short circuit type.

21. The method of claim 20, wherein the type of short circuit is a short between the anode pin and the cathode pin or a short between the anode pin and a ground.

22. The method of claim 20, wherein the short circuit and the short circuit type are detected using a voltage of the anode pin.

23. The method of claim 22, wherein the short between the anode pin and the ground is detected when the anode pin voltage is at ground voltage.

24. The method of claim 22, wherein the short between the anode pin and the cathode pin is detected when the anode pin voltage is higher than ground voltage.

25. The method of claim 20, wherein indicating is visual.

26. The method of claim 20, wherein indicating is audible.
